# EUROPEAN PATENT APPLICATION

(11) **EP 2 624 669 A2**
(43) Date of publication of application: **07.08.2013**
(21) Application number: 13000503.6
(22) Date of filing: 01.02.2013
(51) Int. Cl.: H05K 1/18

(54) **A capacitive sensor for printed circuit boards and an set made of capacitive sensor and a printed circuit board**

(30) Priority: 03.02.2012 PL 39799512
(71) Applicant: Diehl AKO Stiftung & Co. KG, 88239 Wangen (DE)
(72) Inventor: Meller, Pawel, 46-100 Namyslow (PL)
(74) Representative: Diehl Patentabteilung

(57) **Abstract**

The invention concerns a capacitive sensor (1) for printed circuit boards (7), containing a platform (2) for sensing the presence of an element across an insulating sheet. The platform (2) is articulated to at least one elastically deformable support (3), adapted for fastening to a printed circuit board (7) in order to hold the platform (2) above this printed circuit board (7). An edge clip (4) is formed at the free end of one support (3), which is used for seating on an edge segment of the printed circuit board (7). The edge clip (4) has a boundary wall (4a) and, connected to it, a first clamping part (4b) and a second clamping part (4c), opposite each other.

The invention also concerns a set made up of a capacitive sensor (1) and a printed circuit board (7), which contains printed circuit tracks (9) situated on at least one surface of the printed circuit board (7), in which one of the first clamping part (4b) and the second clamping part (4c) of the clip (4) of the capacitive sensor (1) forms an electrical contact with a printed circuit track (9) situated on the selected surface of the printed circuit board (7).

## Description

The subject of the invention is a capacitive sensor for printed circuit boards and set made up of capacitive sensor and printed circuit board. The invention is intended for use in sensor keypads used in connection with printed circuit boards in various electrically operated devices.

Capacitive sensors used with printed circuit boards are employed to detect the presence of a certain element, such as the user's finger, across an electrically insulating layer, such as glass or ceramic. The capacitive sensor is electrically connected to an electronic circuit, such as a printed circuit board, which detects a change in capacitance when the element makes contact with or approaches the sensor and transforms these changes into an active or inactive state of the device.

From patent specification EP0780865 there is known a capacitive sensor designed for mounting on a printed circuit board. The sensor contains a flexible element, which is formed as a single piece and has the shape of a flexible oblong sheet of material conducting an electric current, bent in the shape of the letter Z. The flexible element contains a platform and a support, which has a base essentially parallel with the platform and a middle part joining them. In the base there are formed pins, also being of one piece with it, for fastening the flexible element to the printed circuit board. The support is connected to the platform at one edge of the platform. The sensor is fastened to the printed circuit board by placing the pins into openings and soldering them to form an electrical connection. This is tedious and time-consuming.

The goal of the invention is to develop a capacitive sensor that has a design which ensures a simple and secure fastening of the sensor to the edge of the printed circuit board.

The next goal of the invention is to ensure an electrical connection with the printed circuit tracks situated on one of the surfaces of the printed circuit board, on which the sensor is mounted.

The capacitive sensor for printed circuit boards according to the invention, containing a platform for sensing the presence of an element across an insulating sheet, which platform is articulated to at least one elastically deformable support, adapted for fastening to a printed circuit board in order to hold the platform above this printed circuit board, is characterized in that an edge clip is formed at the free end of one support, which is used for seating on an edge segment of the printed circuit board and which has a boundary wall and, connected to it, a first clamping part and a second clamping part, opposite each other.

Advantageously, the edge clip contains a collar situated at the other end of the clamping part.

Advantageously, on at least one of the first clamping part and the second clamping part there is formed a contact embossing directed toward the middle of the edge clip.

Advantageously, the support has an end part, which is curved and parallel to the platform, and the edge clip is situated at the free end of the end part.

Advantageously, on the end part there is formed a locking element for locking the capacitive sensor in the assembled position on the printed circuit board.

Advantageously, the platform is connected to a second support, adapted for insertion in an opening in the printed circuit board, in order to lock the capacitive sensor in the assembled position.

According to another aspect of the invention, a set made up of a capacitive sensor as presented above and a printed circuit board, which contains printed circuit tracks situated on at least one surface of the printed circuit board, is characterized in that at least one of the first clamping part and the second clamping part of the clip of the capacitive sensor forms an electrical contact with a printed circuit track situated on a selected surface of the printed circuit board.

The capacitive touch sensor according to the invention provides a secure, self-locking fastening to the edge of a printed circuit board, eliminating the need to use additional assembly methods such as soldering.

The edge clip, via the first and second clamping part, assures an electrical connection of the capacitive sensor to the printed circuit tracks situated on one of the surfaces of the printed circuit board and thereby preserves the properties of the electrical connection regardless of the kind of printed circuit board used.

The term "lengthwise direction" refers to the direction designated by the intersection of the plane of symmetry of the support and the platform of the sensor. The "transverse direction" is the direction perpendicular to the lengthwise direction.

The subject of the invention in example embodiments is indicated in the drawing, where:
Figure 1 shows a first example embodiment of the capacitive sensor in perspective view;
Figure 2 shows the capacitive sensor from Fig.1 in a side view;
Figure 3 shows in side view and magnified view a fragment of the capacitive sensor with edge clip and locking element;
Figure 4 shows a second example embodiment of the capacitive sensor in perspective view;
Figure 5 shows the capacitive sensor of Fig. 4 from the side.

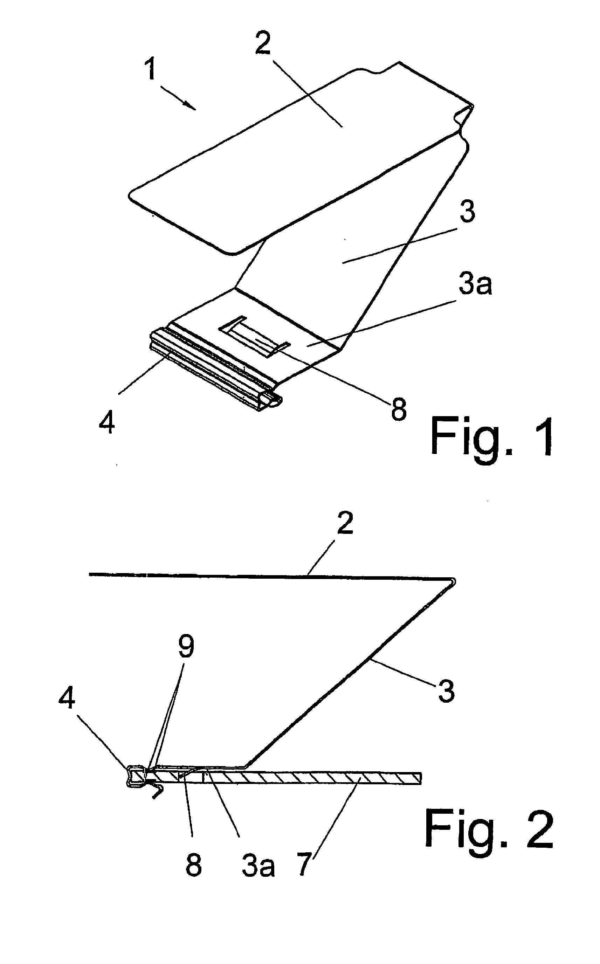

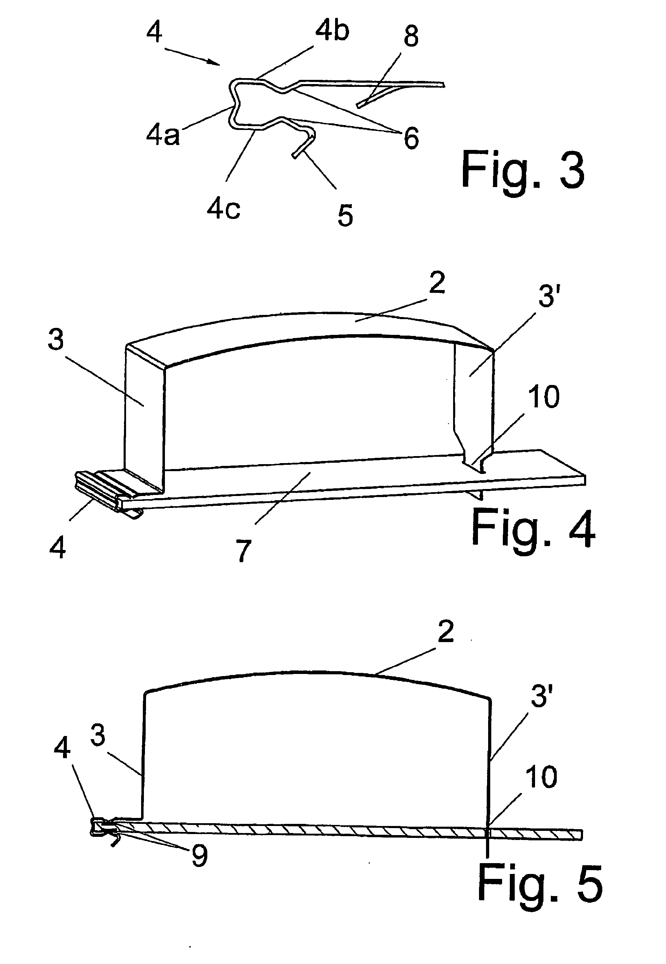

The capacitive sensor 1 is presented in a first example embodiment in Fig. 1-3 and in a second example embodiment in Fig. 4-5. In the drawings, corresponding parts of the sensor are designated by identical reference numbers.

In the first example embodiment, the capacitive sensor 1 contains a platform 2 for sensing the presence of an element across an insulating sheet (not shown). The platform 2 is articulated to at least one elastically deformable support 3, which is adapted for fastening to a printed circuit board 7 (shown in Fig. 2) in order to hold the platform 2 at a certain distance from the printed circuit board 7.

The articulation of the support 3 with the platform 2 and its flexibility allow the platform 2 to be displaced vertically, and also to be turned about the axis of the articulation, and thereby adapt the position of the platform 2 to the surface of the insulating element (not shown) which presses on the sensor from above.

In this example embodiment, the platform 2 has a rectangular shape. However, the shape of the platform 2 can be different, especially oval or circular. Also arbitrary and dictated by the defined application is the shape of the support 3. In the present example embodiment, the support 3 has the shape of a curved rectangular sheet, whose end part 3a is designed to be placed in the vicinity of the surface of the printed circuit board 7. The end part 3a of the support 3 and the platform 2 can be essentially parallel to each other, but in particular applications they can be placed on a slant relative to each other by adjusting the placement of the platform 2 to this placement of the insulating element.

According to the invention, at the free end of the end part 3a there is fashioned an edge clip 4, which serves to fasten the sensor 1 on the selected segment of the edge of the printed circuit board 7 in a way covering the surface of the printed circuit board 7.

In the present example embodiment, the clip 4 has a contour close to rectangular, looking in the transverse direction of the sensor 1. The clip 4 contains a first clamping part 4b, being an extension of the end part 3a of the support 3, a boundary wall 4a, extending from the first clamping part 4b and designed to make contact with the edge surface of the printed circuit board 7, and a second clamping part 4c, opposite and essentially parallel to the first clamping part 4b, starting from the boundary wall 4a. Even so, the edge clip 4 can have a different contour, such as a round one, in which case the boundary wall 4a, the first clamping part 4b and the second clamping part 4c will have contours of arc segments.

At the end part 3a of the support 3 there is also formed a locking element 8, here in the form of a downwardly curving tongue, for locking the capacitive sensor 1 in the position assembled on the printed circuit board 7.

During the fastening of the sensor 1 on the printed circuit board 7, the edge of the printed circuit board 7 is shoved between the first clamping part 4b and the second clamping part 4c until the edge surface of the printed circuit board 7 makes contact with the boundary wall 4a. During the shoving of the edge of the printed circuit board 7 into the edge clip 4, the locking element 8 is placed in an opening made in the printed circuit board 7, in order to protect the sensor 1 against spontaneous sliding from the printed circuit board 7.

The second clamping part 4c is provided with a collar 5, assisting the edge of the printed circuit board 7 in being introduced into the edge clip 4.

In the first and second clamping part 4b, 4c there are also made lengthwise embossings 6, which form a contact with the surfaces of the printed circuit board 7. Given that the clip 4, besides the function of mechanical fastening of the sensor 1 to the printed circuit board 7, also plays the role of an electrical connection, because the first clamping part 4b and the second clamping part 4c rest against their corresponding surfaces of the printed circuit board 7 and make contact with the printed circuit tracks 9 situated on them, the embossings 6 on the first clamping part 4b and the second clamping part 4c provide a durable electrical contact with the printed circuit tracks 9, regardless of the shape of the platform 2 or the support 3 of the sensor.

As is shown in Fig. 2, in the set formed from a capacitive sensor 1 and a printed circuit board 7 the clip 4 can provide electrical contact with the printed circuit track 9 situated either on the surface of the printed circuit board 7 on the sensor 1 side or on the opposite side (the drawing shows both instances).

A second example embodiment of the sensor 1 according to the invention, shown in Fig. 4-5, contains two supports 3, 3', articulated to opposite edges of the platform 2. One support 3 has at its free end an edge clip 4 with the design presented in regard to the first example embodiment, which is situated perpendicular to the support 3. The other support 3' is designed to be placed in a through hole in the printed circuit board 7 in order to lock the capacitive sensor 1 in the assembled position. The second support 3' can be terminated by at least one locating pin 10, playing the same function as the locking element 8 from the first example embodiment.

The pin 10 allows a vertical displacement of the support 3', and thus the platform 2, in a limited range, while after achieving the position of locking in the hole of the printed circuit board 7 it provides pressure of the platform 2 on the surface of the insulating element (not shown), applied from above.

As in the first example embodiment, during the fastening of the sensor 1 on the printed circuit board 7 the edge of the printed circuit board 7 is shoved between the first clamping part 4b and the second clamping part 4c until the edge surface of the printed circuit board 7 makes contact with the boundary wall 4a, holding the second support 3' above the printed circuit board 7. Next, the pin 10 of the second support 3' is placed in the hole made in the printed circuit board 7 in order to protect the sensor 1 from spontaneous sliding off of the printed circuit board 7.

As shown in Fig. 5, in the set made up of the capacitive sensor and the printed circuit board 7 the clip 4 assures an electrical contact with the printed circuit track 9 situated on the surface of the printed circuit board 7 on the sensor 1 side or on the opposite side (the figure shows both instances).

These and other modifications obvious to the skilled person in this field are covered by the enclosed patent claims which define the scope of protection of the invention.

### REFERENCE NUMBERS

- 1: capacitive touch sensor
- 2: platform
- 3: support
- 3': support
- 3a: end part
- 4: edge clip
- 4a: boundary element
- 4b: first clamping part
- 4c: second clamping part
- 5: collar
- 6: embossing
- 7: printed circuit board
- 8: locking element
- 9: printed circuit track
- 10: pin

## Claims

1. Capacitive sensor (1) for printed circuit boards (7), containing a platform (2) for sensing the presence of an element across an insulating sheet, which platform (2) is articulated to at least one elastically deformable support (3), adapted for fastening to a printed circuit board (7) in order to hold the platform (2) above this printed circuit board (7), **characterized in that** an edge clip (4) is formed at the free end of one support (3), which is used for seating on an edge segment of the printed circuit board (7) and which has a boundary wall (4a) and, connected to it, a first clamping part (4b) and a second clamping part (4c), opposite each other.

2. Sensor according to Claim 1, **characterized in that** the edge clip (4) contains a collar (5) situated at the other end of the clamping part (4c).

3. Sensor according to Claim 1 or 2, **characterized in that** on at least one of the first clamping part (4b) and the second clamping part (4c) there is formed a contact embossing (6) directed toward the middle of the edge clip (4).

4. Sensor according to Claims 1 to 3, **characterized in that** the support (3) has an end part (3a), which is curved and parallel to the platform (2), and the edge clip (4) is situated at the free end of the end part (3a).

5. Sensor according to Claim 4, **characterized in that** on the end part (3a) there is formed a locking element (8) for locking the capacitive sensor (1) in the assembled position on the printed circuit board (7).

6. Sensor according to Claims 1 to 3, **characterized in that** the platform (2) is connected to a second support (3), adapted for insertion in an opening in the printed circuit board (7), in order to lock the capacitive sensor (1) in the assembled position.

7. Set made up of a capacitive sensor according to Claims 1 to 6 and a printed circuit board (7), which contains printed circuit tracks (9) situated on at least one surface of the printed circuit board (7), **characterized in that** one of the first clamping part (4b) and the second clamping part (4c) of the clip (4) of the capacitive sensor (1) forms an electrical contact with a printed circuit track (9) situated on the selected surface of the printed circuit board (7).
